Europäisches Patentamt

European Patent Office

Office européen des brevets

(11) Veröffentlichungsnummer: **0 252 347**

A2

(12) **EUROPÄISCHE PATENTANMELDUNG**

(21) Anmeldenummer: 87108755.7

(22) Anmeldetag: 19.06.87

(51) Int. Cl.⁴: **C30B 25/02** , **C30B 29/42**

(30) Priorität: 11.07.86 DE 3623508

(43) Veröffentlichungstag der Anmeldung:
13.01.88 Patentblatt 88/02

(84) Benannte Vertragsstaaten:
AT BE CH DE ES FR GB GR IT LI LU NL SE

(71) Anmelder: Battelle-Institut e.V.
Am Römerhof 35 Postfach 900 160
D-6000 Frankfurt/Main 90(DE)

(72) Erfinder: Bonnet, Dieter, Dr.
Breslauer Ring 9a
D-6382 Friedrichsdorf(DE)

(54) Vefahren zur Abscheidung von Galliumarsenidschichten.

(57) Die Erfindung bezieht sich auf ein Verfahren zur Abscheidung von Galliumarsenidschichten auf einem erhitzten Substrat. Dabei wird Gallium nach seiner Verdampfung im Vakuum ionisiert und als Haufenionen zum Substrat hin elektrisch beschleunigt. Nach der Erfindung werden dem erhitzten Substrat gleichzeitig gasförmige anorganische oder organische Arsenverbindungen zugeführt, die durch das erhitzte Substrat Arsen freisetzen, das mit den beschleunigten Galliumhaufenionen direkt reagiert. Die Reste der zerfallenen Arsenverbindungen werden abgesaugt.

EP 0 252 347 A2

## Verfahren zur Abscheidung von Galliumarsenidschichten

Die Erfindung bezieht sich auf ein Verfahren zur Abscheidung von Galliumarsenidschichten, insbesondere einkristalliner Schichten, bei dem das Gallium nach seiner Verdampfung im Vakuum ionisiert und in Form von Haufenionen unter Anlegen eines elektrischen Feldes zu einem erhitzten Substrat hin beschleunigt wird.

Für die Mikroelektronik werden höchst perfekte epitaktische Schichten auf Galliumarsenid-Wafern benötigt. Für Solarzellen arbeiten weltweit Entwicklungsgruppen sowohl an einkristallinen als auch an polykristallinen Schichten. Während einkristalline Schichten Anwendung sowohl im Weltraum als auch auf der Erde, dann aber ausschließlich in Konzentratorsystemen finden werden, sind polykristalline Dünnschichtstrukturen für direkt zu beschichtende Solarzellen von Interesse.

Das erste technisch beherrschte Abscheideverfahren ist die Flüssigphasenepitaxie, die zur Herstellung von Laserdioden und LED's (lichtemittierende Dioden) eingesetzt wird. Hierbei kristallisiert Galliumarsenid, das in einer Galliumschmelze gelöst ist, im Kontakt mit der zu beschichtenden Scheibe einkristallin aus und kann dann weiterverarbeitet werden. Dieses Verfahren ist für die kostengünstige Herstellung großflächiger Strukturen nicht geeignet.

Ferner ist das Molekularstrahl-Epitaxieverfahren bekannt, das wegen des hohen Aufwandes für das dazu erforderliche Ultravakuum zur Beschichtung großer Flächen ebenfalls nicht geeignet ist. Bei diesem Verfahren wird eine Galliumarsenidschicht durch abwechselnde Abscheidung je einer Monolage von Gallium und Arsen auf dem Substrat erzeugt. Da dies ein sehr langsamer Prozess ist, muß ein sehr gutes Vakuum als Umgebung verwendet werden, da sonst der Verunreinigungsgrad, z. B. durch Sauerstoff, unerwünscht hoch würde und die elektronischen Eigenschaften der Schichten verschlechtert würden.

Seit einiger Zeit wird das Verfahren der organischen Abscheidung (MOCVD) verfolgt. Hierbei werden flüchtige organische Verbindungen von Gallium und Arsen auf dem erhitzten Substrat zur Zersetzung und die Elemente Gallium und Arsen, die dabei frei werden, zur Reaktion gebracht. In einer bereits vor vielen Jahren untersuchten Modifikation wurden Galliumchlorid und Arsenwasserstoff umgesetzt. Dieses Verfahren hat allerdings den Nachteil, daß einerseits das Gallium in einem Reaktor als Vorrat für den gesamten Prozess eingebracht werden und der Reaktor zusätzlich insgesamt mit einem komplizierten Temperaturprofil versehen werden muß, damit das Galliumarsenid nur auf dem gewünschten Substrat kondensiert. Ferner kann hierbei die Freisetzung von Salzsäure nicht verhindert werden.

In aller Fällen der bekannten Verfahren und besonders auch bei der organischen Abscheidungsmethode müssen zur Schichtbildung sehr hohe Substrattemperaturen eingesetzt werden. Dies ist besonders bei neutralen Substraten nachteilig. Hier ist die Kondensator von Schichten nur bei Temperaturen um 900 °C möglich, was die Substratauswahl erheblich einschränkt. Außerdem werden mit diesen Verfahren nur Schichten mit sehr rauher Oberfläche erzielt, die für die weitere Verwendung von Galliumarsenid dessen Einsatzmöglichkeit stark vermindert.

In jüngster Zeit wurden Verfahren untersucht, die auch mit Erfolg in anderen Bereichen der Technik, nämlich der Hartstoffschichten, z. B. aus Titannitrid, eingesetzt wurden. Sie werden als "ionenunterstützte Verfahren" bezeichnet. Wenn die abzuscheidenden Elemente, wie z. B. Gallium und Arsen, nach ihrer Verdampfung im Vakuum ionisiert werden, können sie elektrisch zum Substrat hin beschleunigt werden. Sie erhalten so in Form einer kinetischen Energie eine virtuelle Temperatur, die so wirkt, als wäre das Substrat auf einer erheblich höheren Temperatur als es wirklich der Fall ist. Es können damit Schichten bei niedrigeren Temperaturen als bisher üblich abgeschieden werden. Nach diesem Verfahren wurden bereits verschiedene Halbleiter hergestellt. Dabei werden statt Einzelionen, Haufenionen (ion-clusters) erzeugt, ionisiert und zum Substrat hin beschleunigt. Durch Abscheidung von Haufenionen aus Gallium zusammen mit Haufenionen aus Arsen lassen sich auch epitaktische Galliumarsenidschichten erzielen. Dabei muß aber der Nachteil in Kaufgenommen werden, daß nicht nur das Substrat, sondern auch die Umgebund, d. h. praktisch das gesamte Vakuumreaktionsgefäß mit Arsen bedeckt wird, was für das Bedienungspersonal zu Gesundheitsrisiken und damit zu erhöhten Sicherungskosten führt. Weiterhin kann das Arsen aufgrund seines relativ hohen Dampfdrucks zu der Galliumquelle gelangen und bereits dort mit dem Gallium zu Galliumarsenid reagieren und die Quelle verstopfen. Darüber hinaus sind die erzielen Schichten nicht zufriedenstellend, weil sie viele nicht erwünschte kleinere Kristallite enthalten, die auch noch in ihrer Größe stark schwanken.

Aufgabe der Erfindung ist es daher, ein Verfahren zur Abscheidung von Galliumarsenidschichten zu entwickeln, mit dem eine homogene und glatte Schicht hoher Reinheit mit großen Körnern in gleichmäßiger Verteilung erzielt wird, wobei die Nachteile der bisher bekannten Verfahren vermieden werden. ·

Die Aufgabe ist nach der Erfindung dadurch gelöst, daß in die auf der Oberfläche des erhitzten Substrates eintreffenden Gallium-Haufenionen gasförmige anorganische oder organische Arsenverbindungen injiziert werden, die beim Auftreffen auf dem erhitzten Substrat Arsen freisetzen, das an der Oberfläche des Substrates direkt mit dem Gallium reagiert und daß die Reste der zerfallenen Arsenverbindungen abgesaugt werden.

Weitere Merkmale und Einzelheiten der Erfindung sind in den Ansprüchen 2 und 3 enthalten. In der nachfolgenden Beschreibung ist das erfindungsgemäße Verfahren näher erläutert.

Nach der Erfindung werden die gewünschten polykristallinen und einkristallinen Galliumarsenidschichten aus Gallium und anorganischen oder organischen Arsenverbindungen hergestellt. Da das Metall Gallium bei üblichen Temperaturen einen sehr niedrigen Dampfdruck hat und einen zur Verdampfung ausreichenden Dampfdruck erst oberhalb von 1300 °C entwickelt, wird es im Vakuum in Form von Haufenionen, d. h. "ion-cluster", verdampft und ionisiert. Die Haufenionen werden dann durch ein elektrische Feld zum Substrat hin beschleunigt und erhalten dadurch in Form einer kinetischen Energie eine virtuelle Temperatur, die so wirkt, als wäre das Substrat auf einer erheblich höheren Temperatur als es in Wirklichkeit ist. Das Substrat braucht dabei nur noch auf eine Temperatur von maximal 500 °C erhitzt zu werden, wodurch eine größere Substratauswahl möglich ist und somit auch billigere Substrate verwendet werden können.

Gleichzeitig wird dem erhitzen Substrat z. B. durch eine entsprechend ausgebildete Düse eine anorganische oder organische Arsenverbindung in Gasform zugeführt, die beim Auftreffen auf dem erhitzten Substrat Arsen freisetzt, das mit dem in Haufenionen eintreffenden Gallium direkt reagiert. Die Reste der zerfallenen Arsenverbindungen werden während des Abscheidungsprozesses abgesaugt. Die Schichtabscheidung erfolgt nur auf dem erhitzten Substrat und nicht an den Wänden der unter Vakuum stehenden Herstellungseinrichtung. Es bildet sich eine homogene, glatte Galliumarsenid-Schicht mit vielen großen Körnern bei gleichmäßiger Größenverteilung. Es können damit sowohl Halbleiter für extrem schnelle integrierte Schaltungen höherer Dichte als auch Dünnschichtsolarzellen hergestellt werden, die Schichten höchster Reinheit erfordern.

Als organische Arsenverbindungen eignen sich insbesondere Trimetyl-oder Triäthylverbindungen.

Besonders gute Ergebnisse werden durch Verwendung von Arsin ($AsH_3$) erzielt. Hierbei entsteht unmittelbar vor dem Substrat nascierender Wasserstoff, der aufgrund seiner erheblich reduzierten chemischen Wirkung die lokale Umgebung des Substrates in einem Zustand höchster Reinheit versetzt, so daß die Schicht einerseits unter dem positiven Einfluß der virtuellen Temperatur der beschleunigten Gallium Haufenionen, andererseits unter Vermeidung der problematischen Arsenverunreinigung aufwachsen kann. Die erfindungsgemäße Schichtbildung auf dem Substrat erfolgt bei erheblich niedrigeren Temperaturen als bei den bekannten Verfahren der Flüssigphasen-oder Molekularstrahlepitaxie und der organischen Abscheidung von flüchtigen Gallium-und Arsenverbindungen.

**Ansprüche**

1. Verfahren zur Abscheidung von Galliumarsenidschichten, insbesondere einkristalliner Schichten, bei dem das Gallium nach seiner Verdampfung im Vakuum ionisiert und in Form von Haufenionen unter Anlegen eines elektrischen Feldes zu einem erhitzten Substrat hin beschleunigt wird, <u>dadurch gekennzeichnet</u>, daß in die auf der Oberfläche des erhitzten Substrates eintreffenden Gallium-Haufenionen gasförmige anorganische oder organische Arsenverbindungen injiziert werden, die beim Auftreffen auf dem Substrat Arsen freisetzen, das an der Oberfläche des Substrates direkt mit dem Gallium reagiert, und daß die Reste der zersetzten Arsenverbindungen abgesaugt werden.

2. Verfahren nach Anspruch 1, <u>dadurch gekennzeichnet</u>, daß als Arsenverbindungen Verbindungen der Formel $AsR_3$ verwendet werden, in der R ein Wasserstoffatom oder einen Alkylrest mit 1 bis 6 C-Atomen, vorzugsweise 1 bis 3 C-Atomen, bedeutet.

3. Verfahren nach Ansprüche 1 und 2, <u>dadurch gekennzeichnet</u>, daß die gasförmigen Arsenverbindungen durch eine Düse auf das Substrat geleitet werden.